# EUROPEAN PATENT APPLICATION

(11) **EP 3 495 917 A1**
(43) Date of publication of application: **12.06.2019**
(21) Application number: 18192437.4
(22) Date of filing: 04.09.2018
(51) Int. Cl.: G06F 1/20, G06F 1/18, H05K 7/20, H05K 7/14

(54) **PRINTED CIRCUIT ASSEMBLY WITH VENTS AND ELECTRONIC DEVICE WITH THE ASSEMBLY**

(30) Priority: 05.12.2017 TW 10618043 U
(71) Applicant: Giga-Byte Technology Co., Ltd., New Taipei City 231 (TW)
(72) Inventor: CHEN, Hung-Cheng, 231 New Taipei City (TW); LIAO, Tse-Hsine, 231 New Taipei City (TW)
(74) Representative: Viering, Jentschura & Partner mbB Patent- und Rechtsanwälte

(57) **Abstract**

A printed circuit assembly (5) includes a printed wiring board (50) and an expansion connector (51). The printed wiring board has a top surface (501), a bottom surface (502), and a specific area (504) defined at the top surface thereof for placement of an expansion card (6). In particular, the printed wiring board defines from top to bottom at least one thermal vent (503) in the specific area for heat dissipation. The expansion connector is disposed on the printed wiring board and is located in the specific area for connection with one side edge (60) of the expansion card.

## Description

### CROSS-REFERENCE TO RELATED APPLICATIONS

This application claims the benefit of the filing date of Taiwan Patent Application No. 106218043, filed on Dec. 5, 2017, in the Taiwan Intellectual Property Office, the disclosure of which is incorporated herein in its entirety by reference.

### BACKGROUND OF THE INVENTION

### 1. Field of the Invention

The present invention relates to a printed circuit assembly and an electronic device equipped with the printed circuit assembly, and more particularly to the printed circuit assembly or the electronic device with thermal vents.

### 2. Description of the Related Art

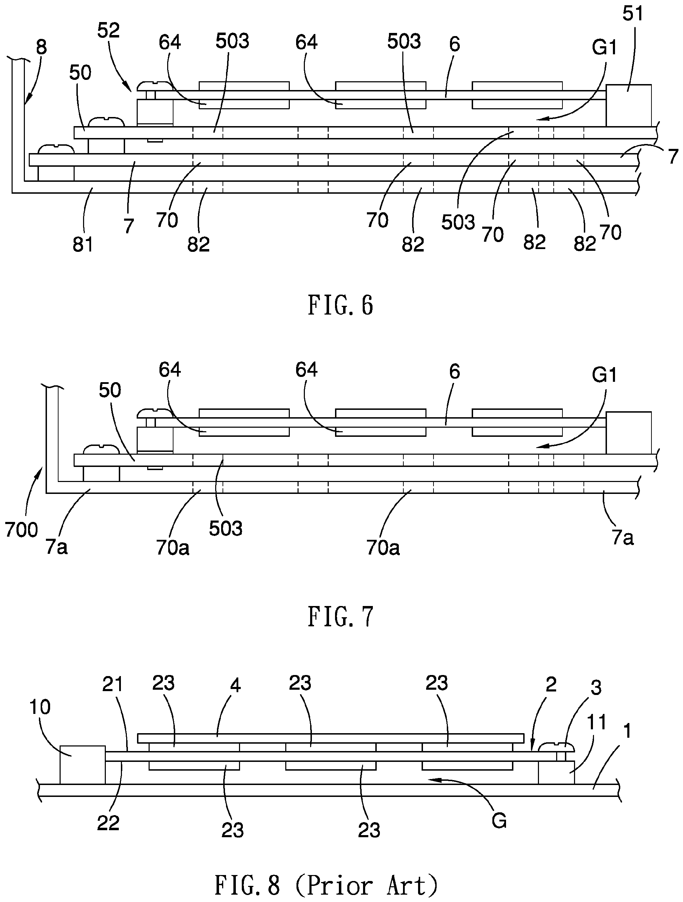

It is well known that a printed circuit assembly, such as motherboard or expansion card, may be equipped with one or more M.2 connectors. The M.2 connectors are provided for connection with a M.2 expansion card, such as M.2 solid-state drive card (M.2 SSD card). As shown in FIG. 8, there is shown a SSD card 2 assembled to a motherboard 1 via a M.2 connector 10 and a threaded standoff 11. Specifically, the M.2 connector 10 and the standoff 11 are both mounted on the mother board 1 and spaced apart in distance. The SSD card 2 has one end engaged with the M.2 connector 10, and the other end held by the standoff 11 and a bolt 3. In addition, on the top and bottom surfaces 21, 22 of the SSD card 2 are a plurality of chips 23, such as NAND flash memory chips or controller chips. Furthermore, a heat sink 4 is provided on top of the chips 23 for heat removal from the chips 23.

However, as can be seen in FIG. 8, since the space G between the SSD card 2 and the motherboard 1 is quiet small and tight, the heat sink 4 can only be arranged on the upper chips 23 on the top surface 21 of the SSD card 2. As such, heat generated by the upper chips 23 can be easily removed, but the heat generated by the lower chips 23 on the bottom surface 22 of the SSD card 2 can hardly be dissipated and thus adversely affect the performance of the SSD card 2.

### SUMMARY OF THE INVENTION

The present invention provides an improved printed circuit assembly to solve the problems mentioned above.

Briefly described, the printed circuit assembly generally includes a printed wiring board and an expansion connector. The printed wiring board has a top surface, a bottom surface, a specific area defined at the top surface thereof for placement of an expansion card, and at least one thermal vent defined in the specific area and extending from the top surface to the bottom surface of the printed wiring board. The expansion connector, such as a M.2 connector, is disposed on the printed wiring board and is located in the specific area for connection with one side edge of the expansion card.

Preferred embodiments of the invention may have the following additional characteristics, either alone or in combination:
The thermal vent represents a letter, a numeral, a symbol or a graphic design in shape.

The printed circuit assembly further includes a fastener disposed in the specific area on the printed wiring board for securing the other side edge of the expansion card.

The fastener includes a threaded standoff and a bolt. The threaded standoff is engaged in a screw hole defined in the printed wiring board for supporting the other side edge of the expansion card. The bolt is engaged in a screw hole of the threaded standoff for securing the other side edge of the expansion card onto the threaded standoff.

The present invention further provides an electronic device with the aforementioned printed circuit assembly. The printed circuit assembly generally includes a printed wiring board and an expansion connector.

Preferably, the electronic device further includes a metal plate on which the printed wiring board is mounted.

Preferably, the metal plate defines at least one through hole corresponding to the at least one thermal vent of the printed wiring board.

The foregoing and other objectives, features, and advantages of the invention will be more readily understood upon consideration of the following detailed description of the invention, taken in conjunction with the accompanying drawings.

### BRIEF DESCRIPTION OF THE DRAWINGS

FIG. 1 is a perspective view of a printed circuit assembly as well as an expansion card in accordance with one embodiment of the present invention;
FIG. 2 is a partial top view of the printed circuit assembly shown in FIG. 1;
FIG. 3 is a partial side view of the printed circuit assembly and the expansion card shown in FIG. 1;
FIG. 4 is a perspective view of a printed circuit assembly as well as an expansion card in accordance with another embodiment of the present invention;
FIGS. 5a∼5d illustrate a variety of printed circuit assemblies with different shapes of thermal vents;
FIG. 6 is a side view of an electronic device in accordance with one embodiment of the present invention;
FIG. 7 is a side view of an electronic device in accordance with another embodiment of the present invention; and
FIG. 8 is a prior art.

### DETAILED DESCRIPTION OF EMBODIMENTS

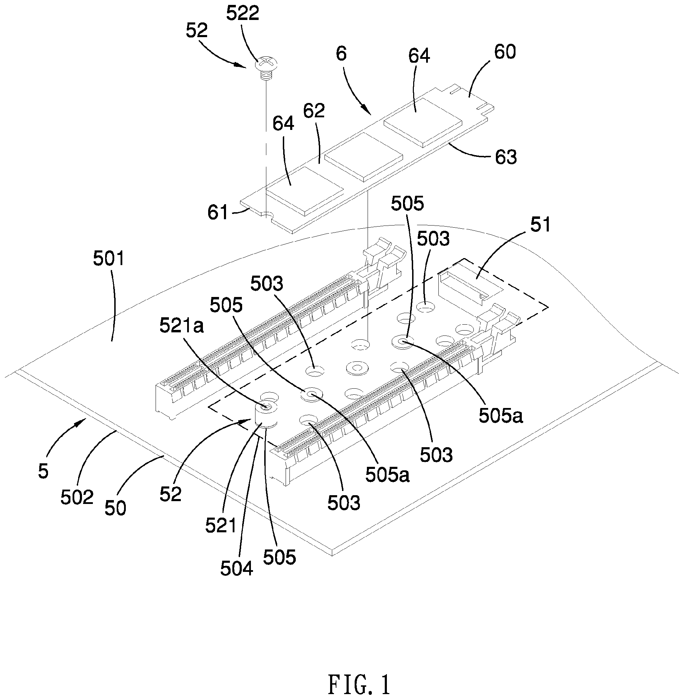

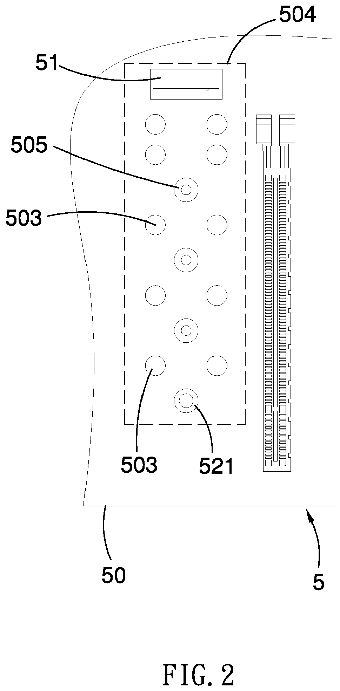

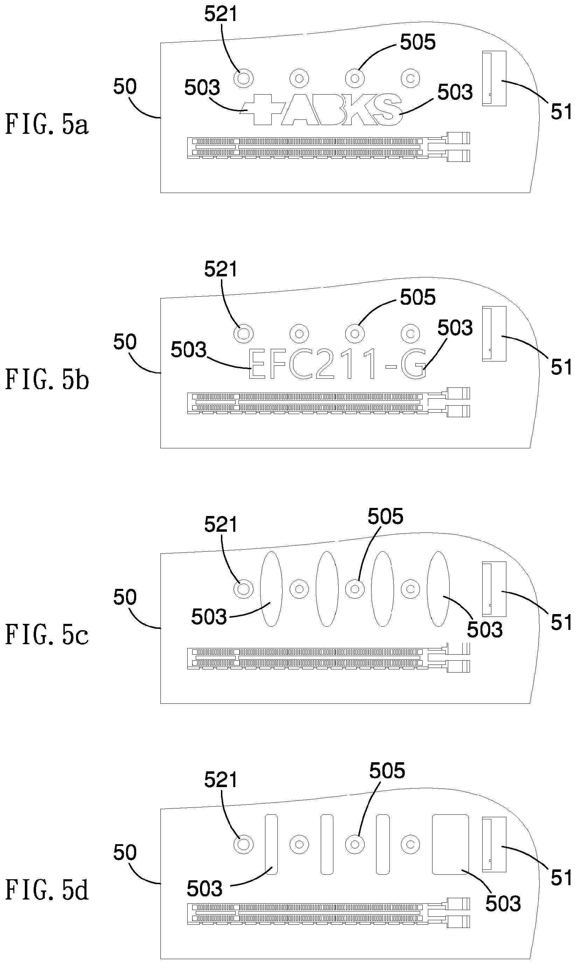

Referring to FIGS. 1 and 2, there is shown one embodiment of a printed circuit assembly 5 on which an expansion card 6 is to be mounted. In this embodiment, the printed circuit assembly 5 is directed to a computer motherboard. However, in other examples, the printed circuit assembly 5 may be a PCIe expansion card, as shown in FIG. 5, or other cards. Briefly, the printed circuit assembly 5 includes a printed wiring board 50 and an expansion connector 51.

The printed wiring board 50 has a top surface 501, a bottom surface 502, a specific area 504 defined at the top surface 501 thereof for placement of the expansion card 6, and one or more thermal vents 503 defined in the specific area 504. Note that each of the thermal vents 503 extends from the top surface to the bottom surface 502 of the printed wiring board 50.

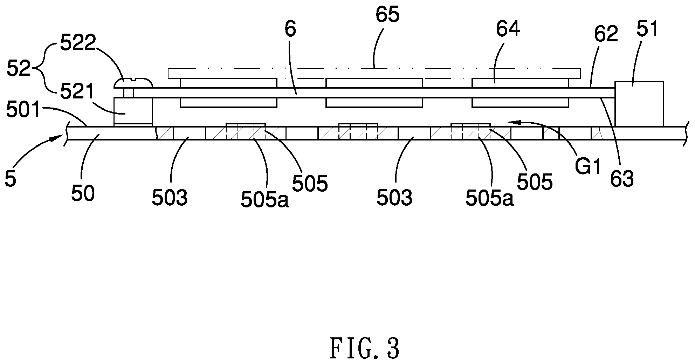

The expansion connector 51 is disposed on the printed wiring board 50 and located in the specific area 504 for connection with one side edge 60 of the expansion card 6, as depicted in FIG. 3. In this embodiment, the expansion connector 51 is directed to a M.2 connector, and the expansion card 6 is directed to a M.2 SSD card. On top and bottom surfaces 62, 63 of the expand card 6 are equipped with a plurality of chips 64, such as NAND flash memory chips or controller chips. In addition, a heat sink 65 is arranged on the upper chips 64 on the top surface 62 of the expansion card 6 for heat dissipation.

As shown in FIGS. 1 and 3, the printed circuit assembly 5 may further includes a fastener 52 disposed in the specific area 504 on the printed wiring board 50 for securing the other side edge 61 of the expansion card 6. More specifically, the printed wiring board 50 is provided with a row of mounting bases 505 each defining a screw hole 505a therein. According to the length of the expansion card 6, the fastener 52 may be selectively inserted in one of the threaded holes 505a of the mounting bases 505. The fastener 52 includes a threaded standoff 521 and a bolt 522. The standoff 521 is screwed in a selected one of the screw holes 505a of the mounting bases 505 for holding the other side edge 61 of the expansion card 6. The bolt 522 is engaged in a screw hole 521a of the standoff 521 to secure the other side edge 61 of the expansion card 6 onto the standoff 521.

It is noted that the amount of the thermal vents 503 may vary as needed. That is, one or more thermal vents 503 may be defined in the printed wiring board 50. Besides, the positions of the thermal vents 503 may also be arranged as required. In this embodiment, there are two rows of thermal vents 503 arranged at opposite sides of the row of the mounting bases 505, as shown in FIG. 1 or 2.

As shown in FIG. 3, there is a small space G1 in between the bottom surface 63 of the expansion card 6 and the top surface 501 of the printed wiring board 50. Though the space G1 is small and tight, it is well ventilated because of the thermal vents 503 that are in communication with the space G1. As such, heat generated by the chips 64 underneath the expansion card 6 can still be well removed via the thermal vents 503, ensuring that the expansion card 6 can function well without overheating problem.

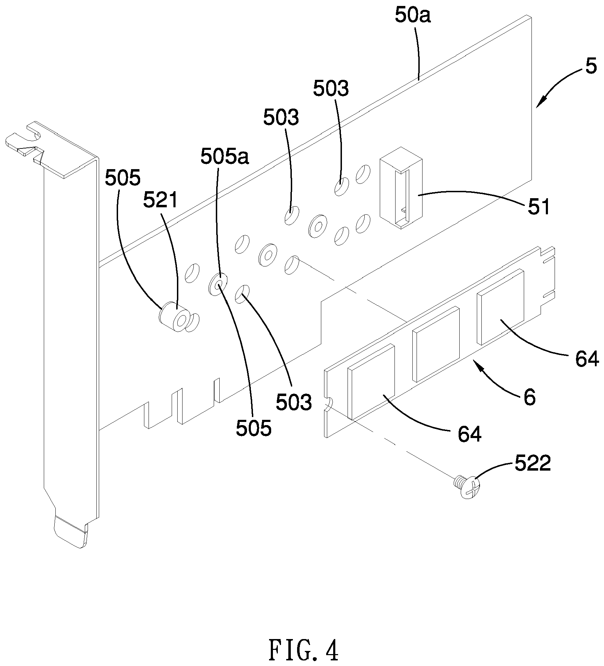

Referring to FIG. 4, there is shown another embodiment of a printed circuit assembly 5 on which an expansion card 6 is to be mounted. In this embodiment, the printed circuit assembly 5 is directed to a PCIe expansion card through which the expansion card 6 (SSD card) can communicate with a motherboard for data transmission.

As shown in FIGS. 5a∼5d, each of the thermal vents 503 may represent a letter, a numeral, a symbol or a graphic design in shape. As shown in FIG. 5a, the set of thermal vents 503 may be arranged with symbol, letter and/or combination thereof. As shown in FIG. 5b, the set of thermal vents 503 may be arranged with letter or numeral and/or combination thereof. As shown in FIGS. 5c and 5d, each of the thermal vents 503 may be ellipse or rectangle in graphics, as desired. It is understood that other shapes may be applied for the thermal vents 503, too.

As shown in FIG. 6, there is shown one embodiment of an electronic device, which generally includes a printed wiring board 50, an expansion connector 51, an expansion card 6 and a threaded standoff 521, as discussed earlier in the aforementioned embodiments, and also a metal plate 7, as discussed further herein. The printed wiring board 50 is mounted on the metal plate 7 which serves a grounding electrode. In this embodiment, the metal plate 7 defines a plurality of through holes 70 respectively corresponding to the thermal vents 503 of the printed wiring board 50 for heat dissipation. The electronic device further includes a chassis 8, and the metal plate 7 is mounted on a bottom plate 81 of the chassis 8. Preferably, one or more holes 82 are defined in the bottom plate 81 of the chassis 8 corresponding to the through holes 70 in the metal plate 7 for heat dissipation.

As shown in FIG. 7, there is shown another embodiment of an electronic device. In this embodiment, the printed wiring board 50 is mounted on a metal plate 7a which serves a grounding electrode. Unlike the aforementioned metal plate 7 shown in FIG. 6, this metal plate 7a is substantially a part of a metallic chassis 700. For instance, the metal plate 7a is a side plate or bottom plate of a computer chassis. Likewise, one or more through holes 70a may be defined in the metal plate 7a corresponding to the thermal vents 503 in the printed wiring board 50 for heat dissipation.

As described above, the printed circuit assembly 5 of the present invention is formed with one or more thermal vents 503 to assist heat dissipation for removing additional heat from the expansion card 6 (such as SSD card) on the printed wiring board 50, thereby solving the overheating problems and improving the performance and functionality of chips 64 of the expansion card 6.

## Claims

1. A printed circuit assembly (5), comprising:
a printed wiring board (50) having a top surface (501), a bottom surface (502), a specific area (504) defined at the top surface (501) thereof for placement of an expansion card (6), and at least one thermal vent (503) defined in the specific area (504) and extending from the top surface (501) to the bottom surface (502) of the printed wiring board (50); and
an expansion connector (51) disposed on the printed wiring board (50) and located in the specific area (504) for connection with one side edge (60) of the expansion card (6).

2. The printed circuit assembly (5) as recited in claim 1, wherein the thermal vent (503) represents a letter, a numeral, a symbol or a graphic design in shape.

3. The printed circuit assembly (5) as recited in claim 1, further comprising a fastener (52) disposed in the specific area (504) on the printed wiring board (50) for securing the other side edge (61) of the expansion card (6).

4. The printed circuit assembly (5) as recited in claim 3, wherein the fastener (52) includes:
a threaded standoff (521) engaged in a screw hole (505a) defined in the printed wiring board (50) for supporting the other side edge (61) of the expansion card (6); and
a bolt (522) engaged in a screw hole (521a) of the threaded standoff (521) for securing the other side edge (61) of the expansion card (6) onto the threaded standoff (521).

5. The printed circuit assembly (5) as recited in claim 1, wherein the expansion connector (51) is a M.2 connector.

6. An electronic device, comprising:
a printed wiring board (50) having a top surface (501), a bottom surface (502), a specific area (504) defined at the top surface (501) thereof, and at least one thermal vent (503) defined in the specific area (504)and extending from the top surface (501) to the bottom surface (502) of the printed wiring board (50);
an expansion connector (51) disposed on the printed wiring board (50) and located in the specific area (504); and
an expansion card (6) disposed in the specific area (504) of the printed wiring board (50) and having a side edge (60) coupled to the expansion connector (51).

7. The electronic device as recited in claim 6, wherein the thermal vent (503) represents a letter, a numeral, a symbol or a graphic design in shape.

8. The electronic device as recited in claim 6, further comprising a fastener (52) disposed in the specific area (504) on the printed wiring board (50) for securing the other side edge (61) of the expansion card (6).

9. The electronic device as recited in claim 8, wherein the fastener (52) includes:
a threaded standoff (521) engaged in a screw hole (505a) defined in the printed wiring board (50) for supporting the other side edge (61) of the expansion card (6); and
a bolt (522) engaged in a screw hole (521a) of the threaded standoff (521) for securing the other side edge (61) of the expansion card (6) onto the threaded standoff (521).

10. The electronic device as recited in claim 6, further comprising a metal plate (7) on which the printed wiring board (50) is mounted.

11. The electronic device as recited in claim 10, wherein the metal plate (7) defines at least one through hole (70) corresponding to the at least one thermal vent (503)of the printed wiring board (50).

12. The electronic device as recited in claim 6, wherein the expansion connector (51) is a M.2 connector, and the expansion card (6) has at least one chip (64) mounted on each of the top and bottom surfaces (62, 63) thereof.
